# EUROPEAN PATENT SPECIFICATION

(11) **EP 3 832 697 B1**
(45) Date of publication and mention of the grant of the patent: **07.06.2023**
(21) Application number: 18928948.1
(22) Date of filing: 02.08.2018
(51) Int. Cl.: H01L 21/3065, H01J 37/32, H05H 1/46

(54) **ATMOSPHERIC-PRESSURE PLASMA GENERATOR**
PLASMAGENERATOR MIT ATMOSPHÄRISCHEM DRUCK
GÉNÉRATEUR DE PLASMA À PRESSION ATMOSPHÉRIQUE

(43) Date of publication of application: 09.06.2021
(73) Proprietor: Fuji Corporation, Chiryu-shi, Aichi 472-8686 (JP)
(72) Inventor: JINDO, Takahiro, Chiryu-shi, Aichi 472-8686 (JP)
(74) Representative: Grünecker Patent- und Rechtsanwälte PartG mbB
(86) International application number: PCT/JP2018/028989
(87) International publication number: WO 2020/026400

(56) References cited:
- EP-A1- 3 282 819
- WO-A1-2018/029845
- JP-A- 2004 315 257
- JP-A- 2007 265 838
- JP-A- 2008 194 674
- JP-A- 2009 062 276
- JP-A- 2018 035 023

## Description

### TECHNICAL FIELD

The present invention relates to an atmospheric pressure plasma gas generator.

### BACKGROUND ART

Conventionally, the temperature control has been carried out in the plasma treatment because the processing quality is affected by the temperature conditions. For example, in a plasma treatment device described in Patent Literature 1, a temperature sensor and a heater are disposed in an interior of a sample table on which a wafer, which is to be etched through a plasma treatment within a vacuum container, is placed and are controlled so as to realize a predetermined temperature. Other atmospheric pressure plasma generators which employ sensors to control temperature, or NOx and/or ozone generation are disclosed in Patent Literatures 2 and 3.

### PATENT LITERATURE

Patent Literature 1: JP-A-2016-213359
Patent Literature 2: EP 3 282 819 A1
Patent Literature 3: WO 2018/029845 A1

### SUMMARY OF THE INVENTION

### TECHNICAL PROBLEM

It has been found out that NOx is generated in an atmospheric-pressure plasma device in the case that a high-temperature plasma gas is generated under an environment in which oxygen and nitrogen exist. Since NOx is harmful to the environment or the like and then constitutes a target substance whose use is restricted by the relevant law and regulations, it is necessary to suppress the generation of NOx.

The present patent application has been made in view of the problem described above, and an object there of is to provide an atmospheric pressure plasma gas generator configured to suppress the generation of NOx.

### SOLUTION TO PROBLEM

Accordingly, the present invention discloses an atmospheric pressure plasma generator according to claim 1. Further embodiments of the invention are disclosed in the dependent claims.

### ADVANTAGEOUS EFFECT OF THE INVENTION

According to the present disclosure, the atmospheric pressure plasma gas generator can be provided which can suppress the generation of NOx.

### BRIEF DESCRIPTION OF DRAWINGS

[Fig. 1] Fig. 1 is a schematic block diagram of an atmospheric pressure plasma generator, which is now attached to an industrial robot.
[Fig. 2] Fig. 2 is a perspective view showing the atmospheric pressure plasma generator.
[Fig. 3] Fig. 3 is a sectional view showing a plasma gas ejection device and a heating gas supply device.
[Fig. 4] Fig. 4 is a block diagram showing a control system of the atmospheric pressure plasma generator.
[Fig. 5] Fig. 5 is a graph showing correlations between generation source temperature and NOx concentration and Ozone concentration.

### DESCRIPTION OF EMBODIMENTS

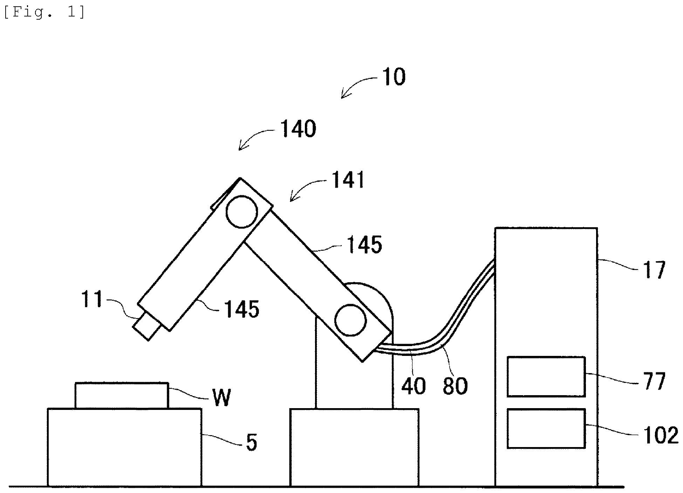

As shown in Fig. 1, atmospheric pressure plasma generator 10 includes plasma head 11, main body section 17, power cable 40, and gas pipe 80 and the like. Main body section 17 includes process gas supply device 77 and cooling gas supply device 102. In atmospheric pressure plasma generator 10, power is transferred from main body section 17 to plasma head 11 via power cable 40, a process gas is supplied to plasma head 11 through gas pipe 80, and a plasma gas is irradiated from plasma head 11. When referred to herein, the process gas refers to a gas in which an active gas such as oxygen and an inert gas such as nitrogen are mixed together at an arbitrary ratio, and the plasma gas refers to an oxygen plasma gas. Plasma head 11 is attached to a distal end of robot arm 141 of industrial robot 140. Power cable 40 and gas pipe 80 are attached in such a manner as to extend along robot arm 141. Robot arm 141 is an articulated robot in which two arm sections 145, 145 are coupled together in one direction. Industrial robot 140 drives robot arm 141 to execute an operation of irradiating a plasma gas on to workpiece W supported on work table 5.

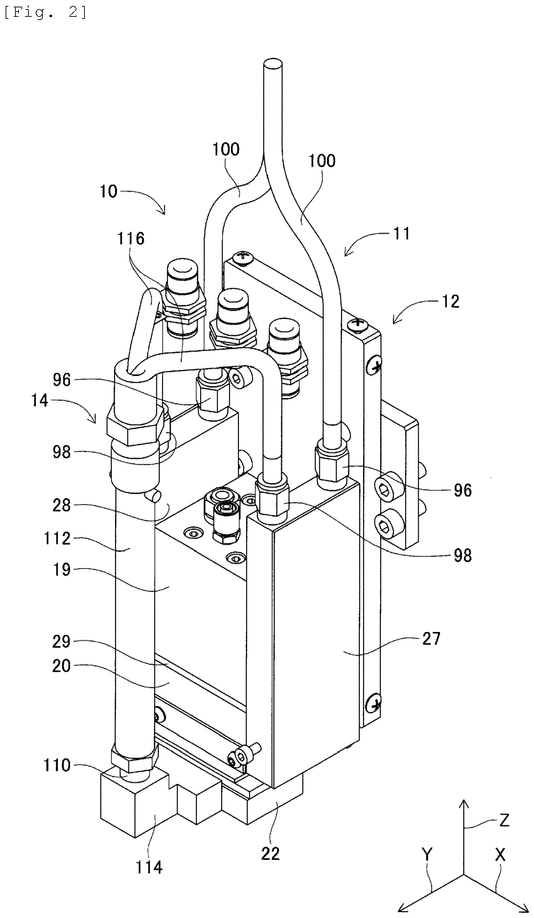

As shown in Fig. 2, plasma head 11 has plasma gas ejection device 12 and heating gas supply device 14. In the following description, a width direction of plasma head 11 refers to an X-direction, a depth direction of atmospheric pressure plasma generator 10 refers to a Y-direction, and a direction at right angles to the X direction and the Y-direction, that is, an up-down direction refers to a Z direction.

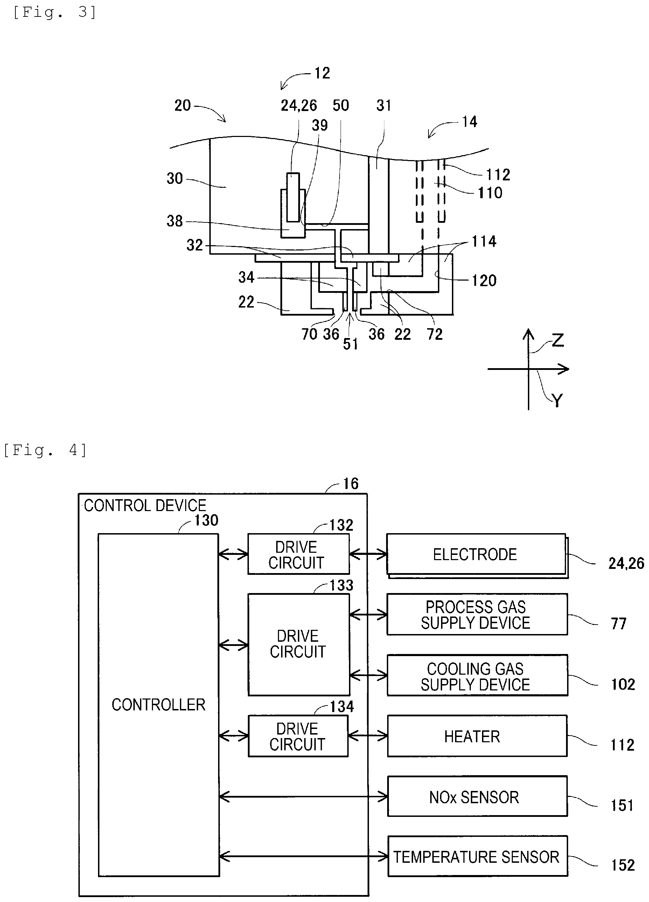

Plasma gas ejection device 12 is configured of upper housing 19, lower housing 20, lower cover 22, pair of electrodes 24, 26 (Fig. 3), and pair of heatsinks 27, 28. Upper housing 19 and lower housing 20 are coupled together via rubber seal member 29 in such a state that upper housing 19 is placed on lower housing 20. Then, upper housing 19 and lower housing 20, which are coupled together, are held by pair of heatsinks 27, 28 therebetween on both side faces thereof which are oriented in the X-direction.

As will be described later, a plasma gas is generated in reaction chamber 38 defined in an interior of lower housing 20, and the plasma gas so generated is ejected downwards from a lower face of lower cover 22. Heatsinks 27, 28 have a function of cooling upper housing 19, lower housing 20, and the like. A flow path reaching from supply port 96 to exhaust port 98 is formed in an interior of each of heatsinks 27, 28. A cooling gas, which is air at about a room temperature, is supplied from cooling gas supply device 102 (refer to Fig. 7) to supply port 96 by way of supply pipe 100. The cooling gas is warmed up through heat exchange and is then let out from exhaust port 98.

Heating gas supply device 14 has gas pipe 110, heater 112, and coupling block 114. Gas pipe 110 is connected to the flow paths defined in the interiors of heatsinks 27, 28 for the cooling gas to flow therethrough. Specifically speaking, gas pipe 110 is connected to exhaust ports 98 of pair of heatsinks 27, 28 by way of exhaust pipe 116 at an upper end portion thereof. Exhaust pipe 116 is bifurcated at a first end portion, and end portions of resulting bifurcated exhaust pipes 16 are coupled to corresponding exhaust ports 98 of pair of heatsinks 27, 28. On the other hand, exhaust pipe 116 is not bifurcated at a second end portion and is connected to an upper end of gas pipe 110. As a result, gas exhausted from pair of heatsinks 27, 28 is supplied into gas pipe 110. Heater 112, having a substantially cylindrical shape, is disposed around an outer peripheral surface of gas pipe 110, so that gas pipe 110 is heated by heater 112. As a result, the gas supplied from heatsinks 27, 28 into gas pipe 110 is heated.

Next, an internal structure of plasma gas ejection device 12 will be described using Fig. 3. Lower housing 20 includes main housing 30, heat dissipation plate 31, earth plate 32, coupling block 34, and nozzle block 36. Main housing 30 has a block-like shape in general, and reaction chamber 38 is formed in an interior of main housing 30. Reaction chamber 38 has an inlet port (not shown) through which a process gas flows in and outlet port 39 through which a plasma gas flows out.

Earth plate 32 functions as a lightning rod and is fixed to a lower face of main housing 30. Coupling block 34 is fixed to a lower face of earth plate 32, and nozzle block 36 is fixed to a lower face of coupling block 34. Heat dissipation plate 31 is disposed on a side face of main housing 30. Heat dissipation plate 31 has multiple fins (not shown), through which heat of main housing 30 is dissipated. Gas flow path 50 is formed in main housing 30, earth plate 32, coupling block 34, and nozzle block 36. Gas flow path 50 communicates with outlet port 39 of reaction chamber 38 at a first end and opens to a lower face of nozzle block 36 at a second end thereof. Opening of gas flow path 50 in nozzle block 36 constitutes outlet port 51.

Coupling block 114 is coupled to a lower end of gas pipe 110 and is fixed to a side face of lower cover 22 which faces heating gas supply device 14 in the Y-direction. Communication path 120 is formed in coupling block 114, and communication path 120 opens to an upper face of coupling block 114 at a first end portion, and communication path 120 opens to a side face of coupling block 114 which faces plasma gas ejection device 12 in the Y-direction at a second end portion thereof. Then, communication path 120 communicates with the lower end of gas pipe 110 at the first end portion, and communication path 120 communicates with through hole 72 in lower cover 22 at the second end portion thereof. As a result, a gas heated in gas pipe 110 is supplied into lower cover 22.

In a control system of atmospheric pressure plasma generator 10, as shown in Fig. 4, control device 16 is connected with process gas supply device 77 and cooling gas supply device 102 in such a manner as to communicate with each other, so that the individual sections are controlled by control device 16. Control device 16 has controller 130, which is configured mainly of a computer, and drive circuits 132 to 134. Drive circuit 132 constitutes a circuit for controlling power to be supplied to electrodes 24, 26. Drive circuit 133 constitutes a circuit for controlling flow rates of gases supplied by process gas supply device 77 and cooling gas supply device 102. Drive circuit 134 constitutes a circuit for controlling power supplied to heater 112. In addition, NOx sensor 151 and temperature sensor 152 are disposed near outlet port 51. A signal indicating a concentration of NOx, which is detected by NOx sensor 151, is output to controller 130. A signal indicating a temperature, which is detected by temperature sensor 152, is output to controller 130.

In atmospheric pressure plasma generator 10, plasma gas ejection device 12 is configured as described above, and in plasma gas ejection device 12, a process gas is plasmatized in the interior of reaction chamber 38, which turns out ejecting plasma gas from a lower end of nozzle block 36. Specifically speaking, a process gas is supplied to the interior of reaction chamber 38 by process gas supply device 77. As this occurs, in reaction chamber 38, a voltage is applied to pair of electrodes 24, 26, which are incorporated in reaction chamber 38, and a current flows between pair of electrodes 24, 26. As a result, a discharge is generated between pair of electrodes 24, 26, whereby the process gas is plasmatized by the discharge, and resulting plasma gas is ejected. In the following description, an ejection of a plasma gas may be referred to as a plasma irradiation from time to time. In the case that heatsinks 27, 28 are not provided, applying a voltage to electrodes 24, 26 under plasmatizing increases a temperature of reaction chamber 38. In atmospheric pressure plasma generator 10, however, a cooling gas is supplied into the flow paths in heatsinks 27, 28 by cooling gas supply device 102, whereby reaction chamber 38 is cooled through heat exchange. The cooling gas that flows through the flow paths in heatsinks 27, 28 and is then warmed up through the heat exchange is supplied into gas pipe 110 and is then heated by heater 112. The cooling gas so heated is then supplied into an interior of lower cover 22 and is then ejected against the plasma gas from through hole 70 in lower cover 22. In addition, through hole 70 is situated in the vicinity of nozzle block 36 and is disposed in the flow path of the plasma gas ejected from the lower end of nozzle block 36. Then, the plasma gas is ejected from through hole 70 in lower cover 22 together with the heated cooling gas. The plasma gas is heated by the heated cooling gas so ejected. Since heater 112 is controlled by control device 16, the temperature of the plasma gas is also controlled.

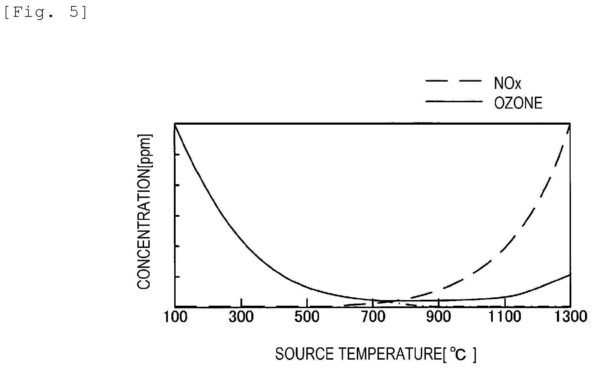

In the present embodiment, oxygen plasma is generated in atmospheric pressure plasma generator 10. It is known that oxygen plasma is combined with oxygen to generate ozone. The inventors measured a concentration of NOx generated in atmospheric pressure plasma generator 10 this time. Fig. 5 is a graph showing concentrations of ozone (a solid line) and NOx (a broken line) with respect to source temperatures. When referred to herein, a source temperature means a temperature in the vicinity, for example, of outlet port 51. For example, a reaction between oxygen radical and nitrogen or a reaction between oxygen and nitrogen under a high-temperature condition can be considered as a NOx generation mechanism. As shown in Fig. 5, it is found that an amount of generation of ozone increases higher as the temperature decreases lower in a temperature range from 100 and 700°C and that an amount of generation of NOx increases higher as the temperature increases higher in a temperature range from 100 and 1300°C. It is considered that the reason that the ozone concentration does not take a concentration indicated by an alternate long and short dash line, that is, a concentration of almost zero but takes a concentration indicated by a solid line at 700 ° C or higher is that NOx reacts with oxygen to thereby generate ozone. It is considered from the reasoning above that the concentration of ozone increases as the concentration of NOx increases. Ozone naturally returns to oxygen, but NOx is not decomposed spontaneously, so when NOx is generated, it is necessary to install a removing device or the like. For this time, paying attention to the temperature dependency of the NOx concentration, the inventors have contrived a control designed to be performed in atmospheric pressure plasma generator 10 as below.

For irradiation of plasma, control device 16 controls the temperature of a plasma gas so that an amount of generation of NOx becomes a threshold or smaller. Specifically speaking, control device 16 controls heater 112 based on a signal output from NOx sensor 151 so that the concentration of NOx becomes the threshold or smaller. Here, the threshold needs to take a value based on, for example, a regulation value regulated by a relevant low or the like. Incidentally, in the present embodiment, reaction chamber 38 is cooled by cooling gas supply device 102, and the temperature of reaction chamber 38 falls down substantially to a temperature ranging from 300 to 400° C. As the temperature of a plasma gas is higher, for example, the effect of plasma irradiation such as imparting hydrophilicity to an object to which plasma is irradiated is improved. Due to this, in the present embodiment, the plasma gas is configured to be heated by the cooling gas which is heated by heater 112. As shown in Fig. 5, when the temperature becomes about 600°C or higher, the concentration of NOx becomes greater than zero. Then, the threshold is set, for example, at a value that slightly exceeds 0 [ppm], and heater 112 is configured to be controlled based on an output signal from NOx sensor 151 so that the concentration of NOx is not greater than the threshold.

More specifically, the threshold is stored in advance in controller 130. Then, for irradiation of plasma, when a concentration of NOx indicated by an output signal from NOx sensor 151 becomes the threshold or greater, control device 16 causes heater 112 to stop heating. Further, control device 16 controls heater 112 based on a signal output from temperature sensor 152 so that the temperature becomes a target temperature. For example, in the case that an object to which plasma is irradiated is made of resin, the object is damaged in the event that a plasma gas is irradiated to the object with temperature higher than the temperature of a melting point of the resin. Then, control device 16 switches on or off heater 12 to cause the cooling gas to heat so that the temperature of the plasma gas becomes its target temperature, the value of which is stored in advance in controller 130. As a result, the temperature of the plasma gas can be set to the target temperature while keeping the amount of generation of NOx at the threshold or smaller.

In the embodiment described heretofore, electrodes 24, 26 represent an example of a pair of electrodes. Heater 112 represents an example of a heater, and heatsinks 27, 28 represent an example of a cooler. The vicinity of outlet port 51 represents an example of a flow path of a plasma gas. The cooling gas represents an example of a cooling heating gas, coupling block 114 and lower cover 22 represent an example of a coupling section, and through hole 70 represents an example of an ejection port. Heating gas supply device 14 and lower cover 22 represent an example of a heating device.

Thus, with the embodiment that has been described heretofore, the following advantageous effects are provided. Control device 16 controls heater 112 based on a signal output from NOx sensor 151 so that the concentration of NOx becomes the threshold or smaller. As a result, the amount of generation of NOx can be limited to the threshold or smaller. In addition, control device 16 controls based on a signal output by temperature sensor 152 so that the temperature becomes the target temperature. As a result, the temperature of the plasma gas can be set to a temperature corresponding to an object to which the plasma gas is irradiated. Further, heating gas supply device 14 heats the cooling gas flowing through gas pipe 110 using heater 112. The plasma gas is heated by ejection of the heated cooling gas. As a result, the temperature of the plasma gas can be controlled by controlling heater 112.

### (Alternative Example 1)

Next, Alternative Example 1 will be described in which atmospheric pressure plasma generator 10 does not include temperature sensor 152 but includes NOx sensor 151. In the case of this configuration, control device 16 controls heater 112 based on a signal output by NOx sensor 151 so that the concentration of NOx becomes the threshold or smaller. As a result, the amount of generation of NOx can be limited to the threshold or smaller.

### (Alternative Example 2)

Next, Alternative Example 2 will be described in which atmospheric pressure plasma generator 10 does not include NOx sensor 151 but includes temperature sensor 152 and an ozone sensor (not shown). In the case of this configuration, control device 16 controls heater 112 based on a signal output by the ozone sensor so that a concentration of ozone becomes a predetermined value or greater. As shown in Fig. 5, with the concentration of ozone staying in a temperature range of up to about 800 °C, an amount of generation of ozone decreases as the temperature increases. On the other hand, the concentration of NOx increases as the temperature increases, and when the temperature exceeds about 600°C, the concentration of NOx becomes greater than zero. Consequently, since the concentration of ozone and the concentration of NOx are both dependent on temperature, the concentration of NOx can be estimated based on the concentration of ozone. Specifically speaking, correlation data between the concentration of ozone and the concentration of NOx is measured, and a value at which the concentration of NOx becomes the threshold or smaller is determined as a lower limit value for the concentration of ozone. Then, the lower limit value for the concentration of ozone so determined is stored in controller 130. Then, for irradiation of plasma, when a concentration of ozone indicated by an output signal from the ozone sensor becomes smaller than the lower limit value, control device 16 causes heater 112 to stop heating. Further, control device 16 controls heater 112 based on a signal output from temperature sensor 152 so that the temperature becomes a target temperature. As a result, the temperature of the plasma gas can be adjusted to a temperature corresponding to an object to which the plasma gas is irradiated while maintaining the concentration of NOx to the threshold or smaller.

### (Alternative Example 3)

Next, Alternative Example 3 will be described in which atmospheric pressure plasma generator 10 does not include NOx sensor 151 and temperature sensor 152 but includes an ozone sensor (not shown). In the case of this configuration, as in the case with (Alternative Example 2), correlation data between the concentration of ozone and the concentration of NOx is measured, and a value at which the concentration of NOx becomes the regulation value or smaller is determined as a lower limit value for the concentration of ozone. Then, the lower limit value for the concentration of ozone so determined is stored in controller 130. Then, for irradiation of plasma, when a concentration of ozone indicated by an output signal from the ozone sensor becomes smaller than the lower limit value, control device 16 causes heater 112 to stop heating. As a result, the concentration of NOx can be set to the threshold value or smaller.

### (Alternative Example 4)

Next, Alternative Example 4 will be described in which atmospheric pressure plasma generator 10 does not include temperature sensor 152 but includes NOx sensor 151 and an ozone sensor (not shown) . In the case of this configuration, as in the case with (Another Example 2), correlation data between the concentration of ozone and the concentration of NOx is measured, and a value at which the concentration of NOx becomes the threshold or smaller is determined as a lower limit value for the concentration of ozone. Then, the lower limit value for the concentration of ozone so determined is stored in controller 130. For irradiation of plasma, when a concentration of NOx indicated by an output signal from NOx sensor 151 becomes the threshold or greater, control device 16 causes heater 112 to stop heating, and when a centration of ozone indicated by an output signal from the ozone sensor becomes the lower limit value or smaller, control device 16 causes heater 112 to stop heating. As a result, an amount of generation of NOx can be set at the threshold or smaller in an ensured fashion.

### (Alternative Example 5)

Next, Alternative Example 5 will be described in which atmospheric pressure plasma generator 10 includes NOx sensor 151, temperature sensor 152, and an ozone sensor (not shown). In the case of this configuration, as in the case with (Alternative Example 4), for irradiation of plasma, when a concentration of NOx indicated by an output signal from NOx sensor 151 becomes the threshold or smaller, control device 16 causes heater 112 to stop heating, and when a concentration of ozone indicated by an output signal from the ozone sensor becomes the lower limit value or smaller, control device 16 causes heater 112 to stop heating. Further, control device 16 switches on or off heater 12 to cause the cooling gas to heat the cooling gas so that the temperature of the plasma gas becomes its target temperature, the value of which being stored in advance in controller 130. As a result, the temperature of the plasma gas can be set to the target temperature while keeping the amount of generation of NOx at the threshold or smaller in an ensured fashion.

### (Alternative Example 6)

Next, Alternative Example 6 will be described in which atmospheric pressure plasma generator 10 does not include NOx sensor 151 but includes temperature sensor 152. In the case of this configuration, correlation data between the concentration of NOx and the temperature is measured, and a value at which the concentration of NOx becomes the threshold or smaller is determined as an upper limit value for the temperature. Then, the upper limit value of the temperature so determined is stored in controller 130. For irradiation of plasma, when a temperature indicated by an output signal from temperature sensor 152 becomes greater than the upper limit value, control device 16 causes heater 112 to stop heating. As a result, the amount of generation of NOx can be maintained at the threshold or smaller.

### (Alternative Example 7)

Next, Alternative Example 7 will be described in which atmospheric pressure plasma generator 10 does not include heater 112 but includes a cooling device (not shown). The embodiment described above adopts the configuration in which reaction chamber 38 is cooled by cooling gas supply device 102, and the plasma gas is heated by the cooling gas heated by heater 112. Since the temperature in reaction chamber 38 rises as a result of application of the voltage to electrodes 24, 26, in the event that reaction chamber 38 is not cooled, the temperature of the plasma gas reaches, for example, a temperature of the order of 1000°C. In (Alternative Example 7), heater 112 is not provided, and a configuration is adopted in which reaction chamber 38 is cooled by the cooling device by taking into consideration a temperature increase in reaction chamber 38 occurring due to the absence of heater 112 so that the temperature of the plasma gas becomes a set temperature. As a cooling device, for example, a configuration is considered in which a feedback control circuit is added in driving circuit 133, the feed back control circuit being configured to adjust a flow rate of a cooling gas which is supplied by cooling gas supply device 102 based on an output signal from temperature sensor 152. That is, in the event that a temperature indicated by temperature sensor 152 is higher than the set temperature, the flow rate of the cooling gas is increased, while in the event that the temperature indicated by temperature sensor 152 is lower than the set temperature, the flow rate of the cooling gas is decreased, whereby the flow rate of the cooling gas is controlled so that the temperature of the plasma gas stays at the set temperature.

In the case of this configuration, control device 16 controls the cooling device based on a signal output by NOx sensor 151 so that the concentration of NOx becomes the threshold or smaller. As a result, the amount of generation of NOx can be limited to the threshold or smaller. In addition, control device 16 controls the cooling device based on a signal output by temperature sensor 152 so that the temperature becomes the target temperature. As a result, the temperature of the plasma gas can be set to a temperature corresponding to an object to which the plasma gas is irradiated. A configuration may be adopted in which any one of the configurations of (Alternative Example 1) to (Alternative Example 6) and the configuration of (Alternative Example 7) are combined with each other arbitrarily. That is, in the configurations of (Alternative Example 1) to (Alternative Example 6), the cooling device may be configured so as to be controlled based on an output signal of each of the sensors.

The present invention is not limited to the embodiment that has been described heretofore, and hence, needless to say, various improvements and alterations or modifications can be made thereto without departing from the scope of the present invention as defined by the claims. For example, in the embodiment described above, heatsinks 27, 28, each including the flow path of the cooling gas formed in the interior thereof, are described as the cooler; however, the present invention is not limited thereto. For example, the cooler may be configured of a heatsink having no flow path of the cooling gas formed in an interior thereof but having multiple fins. In addition, in the embodiment described above, heatsinks 27, 28 are described as cooling reaction chamber 38; however, for example, a configuration may be adopted in which the process gas is cooled by a vortex tube, or a configuration may be adopted in which both the process gas and reaction chamber 38 are cooled. Further, in the case of (Alternative Example 7), too, in addition to the configuration in which the cooling device cools reaction chamber 38, a configuration may be adopted in which the cooling device cools the process gas, or a configuration may be adopted in which the cooling device cools both the process gas and reaction chamber 38.

In addition, in the embodiment described above, NOx sensor 151 and temperature sensor 152 are described as being disposed in the vicinity of outlet port 51; however, the present invention is not limited thereto. For example, a configuration may be adopted in which temperature sensor 152 and NOx sensor 151 are disposed in reaction chamber 38 and gas flow path 50, respectively.

Further, in (Alternative Example 7), the configuration is described in which heater 112 is not provided; however, a configuration may be adopted in which both heater 112 and the cooling device are provided, and control device 16 controls heater 112 and the cooling device so that the temperature of the plasma gas becomes the set temperature.

Furthermore, in the embodiment described above, atmospheric pressure plasma generator 10 is described as including NOx sensor 151 and temperature sensor 152; however, a configuration may be adopted in which an open-loop control is performed without those sensors. Specifically speaking, control conditions of heater 112 under which an amount of generation of NOx becomes the threshold or smaller are obtained through experiments and the like. For irradiation of plasma, a control is performed by following these control conditions.

Additionally, in the embodiment described above, as one example of the heating device, the configuration is described in which the plasma gas is heated by ejecting the cooling gas heated by heater 112; however, the present invention is not limited thereto. For example, a configuration may be adopted in which the plasma gas is heated directly by a heater or the like.

Further, in the embodiment described above, lower housing 20 is described as having earth plate 32; however, the present invention is not limited thereto, and hence, a configuration may be adopted in which lower housing 20 does not have earth plate 32.

### REFERENCE SIGNS LIST

10 Atmospheric Pressure Plasma Generator, 14 Heating Gas Supply Device, 16 Control Device, 22 Lower Cover, 24, 26 Electrode, 27, 28 Heatsink, 38 Reaction Chamber, 110 Gas Pipe, 112 Heater, 114 Coupling Block

## Claims

1. An atmospheric pressure plasma generator (10) comprising:
a pair of electrodes (24, 26) for generating plasma by discharge;
a reaction chamber (38) incorporating the pair of electrodes (24, 26) and having an inlet port through which a process gas flows in and an outlet port (39, 51) through which a plasma gas flows out as a result of the process gas being plasmatized by the pair of electrodes (24, 26), and
a control device (16) for controlling a temperature of the plasma gas flowing out from the outlet port (39, 51) so that an amount of generation of NOx becomes a threshold or smaller
**characterized in that** the atmospheric pressure plasma generator (10) comprises at least one of the following configurations A) to C):
A)
the atmospheric pressure plasma generator (10) comprises a NOx sensor (151) disposed in a flow path of the plasma gas, wherein the control device (16) performs the control based on an output from the NOx sensor (151);
B)
the plasma gas is an oxygen plasma gas,
the atmospheric pressure plasma generator (10) comprises an ozone sensor disposed in the flow path of the plasma gas, and
the control device (16) controls a temperature of the plasma gas based on an output from the ozone sensor so that an amount of generation of ozone falls in a range of a predetermined value or greater;
C)
the atmospheric pressure plasma generator (10) comprises a temperature sensor (152) disposed in the flow path of the plasma gas, wherein the control device (16) controls so that a temperature based on an output from the temperature sensor (152) becomes a target temperature.

2. The atmospheric pressure plasma generator (10) according to claim 1, comprising:
a cooling device for cooling at least either of the process gas and the reaction chamber (38),
wherein the control device (16) controls a temperature of the plasma gas by controlling the cooling device.

3. The atmospheric pressure plasma generator (10) according to claim 1 or 2, comprising:
a cooler (27, 28) for cooling at least either of the process gas and the reaction chamber (38); and
a heating device (14, 22) for heating the plasma gas,
wherein the control device (16) controls a temperature of the plasma gas by controlling the heating device (14, 22).

4. The atmospheric pressure plasma generator (10) according to claim 3,
wherein the cooler (27, 28) has a gas flow path through which a cooling heating gas flows,
wherein the heating device (14, 22) has:
a gas pipe (110) coupled to the gas flow path and through which the cooling heating gas flows;
a heater (112) disposed in the gas pipe (110); and
a coupling section (22, 114) coupled to the gas pipe (110) and having an ejection port (70) opening to a flow path of the plasma gas, and
wherein the plasma gas is heated as a result of the cooling heating gas heated by the heater (112) being ejected from the ejection port (70) against the plasma gas.

## Patentansprüche

1. Atmosphärendruck-Plasmaerzeuger (10), umfassend:
ein Paar Elektroden (24, 26) zur Plasmaerzeugung durch Entladung;
eine Reaktionskammer (38), die das Paar der Elektroden (24, 26) aufnimmt und eine Einlassöffnung aufweist, durch die ein Prozessgas einströmt und eine Auslassöffnung (39, 51), durch welche ein Plasmagas als Ergebnis davon ausströmt, dass das Prozessgas durch das Paar der Elektroden (24, 26) in den Plasmazustand versetzt worden ist, und
eine Steuerungsvorrichtung (16) zur Steuerung einer Temperatur des Plasmagases, das aus der Auslassöffnung (39, 51) ausströmt, so dass eine NOx-Erzeugungsmenge ein Grenzwert oder kleiner wird,
**dadurch gekennzeichnet, dass** der Atmosphärendruck-Plasmaerzeuger (10) mindestens eine der folgenden Konfigurationen A) bis C) umfasst:
A)
der Atmosphärendruck-Plasmaerzeuger (10) umfasst einen NOx-Sensor (151), der in einem Strömungsweg des Plasmagases angeordnet ist, wobei die Steuerungsvorrichtung (16) die Steuerung basierend auf einem Ausgang aus dem NOx-Sensor ausführt;
B)
das Plasmagas ist ein Sauerstoff-Plasmagas,
der Atmosphärendruck-Plasmaerzeuger (10) umfasst einen Ozonsensor, der in dem Strömungsweg des Plasmagases angeordnet ist, und
die Steuerungsvorrichtung (16) steuert eine Temperatur des Plasmagases basierend auf einem Ausgang aus dem Ozonsensor, so dass eine Ozon-Erzeugungsmenge in einen Bereich eines vorgegebenen Werts oder größer fällt;
C)
der Atmosphärendruck-Plasmaerzeuger (10) umfasst einen Temperatursensor (152), der in dem Strömungsweg des Plasmagases angeordnet ist, wobei die Steuerungsvorrichtung (16) so steuert, dass eine Temperatur basierend auf einem Ausgang aus dem Temperatursensor (152) eine Zieltemperatur wird.

2. Der Atmosphärendruck-Plasmaerzeuger (10) nach Anspruch 1, umfassend:
eine Kühlvorrichtung zur Kühlung von mindestens einem von dem Prozessgas und der Reaktionskammer (38),
wobei die Steuerungsvorrichtung (16) eine Temperatur des Plasmagases durch Steuerung der Kühlvorrichtung steuert.

3. Der Atmosphärendruck-Plasmaerzeuger (10) nach Anspruch 1 oder 2, umfassend:
einen Kühler (27, 28) zur Kühlung von mindestens einem von dem Prozessgas und der Reaktionskammer (38); und
eine Heizvorrichtung (14, 22) zur Erhitzung des Plasmagases,
wobei die Steuerungsvorrichtung (16) eine Temperatur des Plasmagases durch Steuerung der Heizvorrichtung (14, 22) steuert.

4. Der Atmosphärendruck-Plasmaerzeuger (10) nach Anspruch 3,
wobei der Kühler (27, 28) einen Gasströmungsweg aufweist, durch den ein Kühlheizgas strömt,
wobei die Heizvorrichtung (14, 22) aufweist:
eine Gasleitung (110), die mit dem Gasströmungsweg verbunden ist und durch welche das Kühlheizgas strömt;
eine Heizung (112), die in der Gasleitung (110) angeordnet ist; und
einen Kopplungsabschnitt (22, 114), der mit der Gasleitung (110) verbunden ist und eine Ausstoßöffnung (70) umfasst, die sich zu einem Strömungsweg des Plasmagases öffnet, und
wobei das Plasmagas dadurch erhitzt wird, dass das von der Heizung (112) erhitzte Kühlheizgas aus der Ausstoßöffnung (70) gegen das Plasmagas ausgestoßen wird.

## Revendications

1. Générateur de plasma à pression atmosphérique (10) comprenant :
une paire d'électrodes (24, 26) pour générer du plasma par décharge ;
une chambre de réaction (38) incorporant la paire d'électrodes (24, 26) et ayant un orifice d'entrée par lequel entre un gaz de traitement et un orifice de sortie (39, 51) par lequel sort un gaz plasma résultant de la plasmatisation du gaz de traitement par la paire d'électrodes (24, 26), et
un dispositif de commande (16) pour commander une température du gaz plasma sortant de l'orifice de sortie (39, 51) de sorte qu'une quantité de génération de NOx devienne inférieure ou égale à un seuil
**caractérisé en ce que** le générateur de plasma à pression atmosphérique (10) comprend au moins l'une des configurations suivantes A) à C) :
A)
le générateur de plasma à pression atmosphérique (10) comprend un capteur de NOx (151) disposé dans un trajet d'écoulement du gaz plasma, dans lequel le dispositif de commande (16) effectue la commande sur la base d'une sortie du capteur de NOx (151) ;
B)
le gaz plasma est un gaz plasma oxygène,
le générateur de plasma à pression atmosphérique (10) comprend un capteur d'ozone disposé dans le trajet d'écoulement du gaz plasma, et
le dispositif de commande (16) commande une température du gaz plasma sur la base d'une sortie du capteur d'ozone de sorte qu'une quantité de génération d'ozone tombe dans une plage supérieure ou égale à une valeur prédéterminée ;
C)
le générateur de plasma à pression atmosphérique (10) comprend un capteur de température (152) disposé dans le trajet d'écoulement du gaz plasma, dans lequel le dispositif de commande (16) effectue une commande de sorte qu'une température basée sur une sortie du capteur de température (152) devienne une température cible.

2. Générateur de plasma à pression atmosphérique (10) selon la revendication 1, comprenant :
un dispositif de refroidissement pour refroidir au moins l'un parmi le gaz de traitement et la chambre de réaction (38),
dans lequel le dispositif de commande (16) commande une température du gaz plasma en commandant le dispositif de refroidissement.

3. Générateur de plasma à pression atmosphérique (10) selon la revendication 1 ou 2, comprenant :
un refroidisseur (27, 28) pour refroidir au moins l'un parmi le gaz de traitement et la chambre de réaction (38) ; et
un dispositif de chauffage (14, 22) pour chauffer le gaz plasma,
dans lequel le dispositif de commande (16) commande une température du gaz plasma en commandant le dispositif de chauffage (14, 22).

4. Générateur de plasma à pression atmosphérique (10) selon la revendication 3,
dans lequel le refroidisseur (27, 28) a un trajet d'écoulement de gaz à travers lequel s'écoule un gaz de refroidissement/chauffage,
dans lequel le dispositif de chauffage (14, 22) a :
un tuyau de gaz (110) couplé au trajet d'écoulement de gaz et à travers lequel s'écoule le gaz de refroidissement/chauffage ;
un réchauffeur (112) disposé dans le tuyau de gaz (110) ; et
une section de couplage (22, 114) couplée au tuyau de gaz (110) et ayant un orifice d'éjection (70) s'ouvrant sur un trajet d'écoulement du gaz plasma, et
dans lequel le gaz plasma est chauffé du fait que le gaz de refroidissement/chauffage chauffé par le réchauffeur (112) est éjecté de l'orifice d'éjection (70) contre le gaz plasma.
